Europäisches Patentamt

European Patent Office

Office européen des brevets

(11) Publication number: **0 009 618**
**B1**

# EUROPEAN PATENT SPECIFICATION

(45) Date of publication of patent specification: **12.09.84**

(21) Application number: **79103178.4**

(22) Date of filing: **28.08.79**

(51) Int. Cl.³: **H 03 J 1/04,** H 03 J 5/00,
H 04 B 1/26

(54) Circuit and method for controlling a channel display in a superheterodyne receiver.

(30) Priority: **28.08.78 JP 105796/78**

(43) Date of publication of application:
**16.04.80 Bulletin 80/08**

(45) Publication of the grant of the patent:
**12.09.84 Bulletin 84/37**

(84) Designated Contracting States:
**DE FR GB**

(56) References cited:
**DE-A-2 362 853**
**DE-A-2 645 833**
**DE-A-2 648 882**
**GB-A-2 002 190**
**US-A-4 024 476**
**US-A-4 048 570**

(73) Proprietor: **SANYO ELECTRIC CO., LTD.**
**18, Keihanhondori 2-chome**
**Moriguchi-shi Osaka-fu (JP)**
(73) Proprietor: **Tottori Sanyo Electric Co., Ltd.**
**201 Yoshikata Tottori-shi**
**Tottori 680 (JP)**

(72) Inventor: **Sumi, Yasuaki**
**127m Mihagino 1-chome**
**Tottori-shi Tottori-ken (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

0 009 618

(58) References cited:
FUNKSCHAU, 48. Jahrgang, Nr. 8/1976,
München, K. HOLETZEK et al. "Ein Hi-Fi-
Spitzen-Receiver mit digitalen Anzeigen",
pages 286 to 290
FUNKSCHAU, 48. Jahrgang, Nr. 9/1976,
München, O. Klank, D. Rottmann "Digitale
Frequenz-Kanal- und Zeitanzeige in einem
Spitzen-Receiver", pages 334 to 337
FUNK-TECHNIK, 33. Jahrgang, Nr. 15/1978,
München und Heidelberg, W. Clas
"Sendereinstellung durch Tastenwahl der
Fernsehkanäle", pages F&E 137-153
FUNK-TECHNIK, 32. Jahrgang, Nr. 22/1977,
München und Heidelberg, Dr.G.Dickopp
"Mikroprozessor als Abstimmhilfe", pages F&E
391,392

## Description

The invention relates to a circuit and method for controlling a channel display in a superheterodyne receiver. More specifically, the invention relates to a superheterodyne receiver comprising frequency data setting means controlled by programming means for setting frequency data corresponding to the value of a frequency to be received, frequency display means controlled by said frequency data for displaying the set frequency value and voltage generating means responsive to said frequency data for generating a control voltage for a local oscillator included in the tuning part of the receiver. Furthermore, the invention relates particularly to a method for controlling a channel display in a superheterodyne receiver including a voltage controlled local oscillator, frequency data setting means controlled by programming means for setting a frequency data associated with a receiving frequency to be selected for controlling the generation of the control voltage for the local oscillator.

A superheterodyne receiver and a controlling method of the above kind are known from the US—A—4 048 570. This receiver has a frequency display which is controlled by the frequency data inputted in the programming means, i.e. the display shows the wanted frequency data rather than the actual frequency data. In order to comfort the user of such a receiver, i.e. to avoid the necessity to correctly memorize the frequencies of a large number of broadcasting stations it has been proposed that in a given frequency band, such as FM band, channel numbers are allotted to the respective broadcasting stations so that a desired broadcasting station can be identified by a corresponding channel number of a decreased number of digits.

Such a display showing the channel number and channel index is known e.g. from GB—A—2 002 190 and DE—A—2 362 853. In these known displays the channel number data for displaying the channel number are obtained by arithmetic conversion from frequency data obtained from the momentary local oscillator frequency.

This method of controlling or this superheterodyne receiver, respectively, has the disadvantage that the programming part of the receiver must be structured from the beginning in terms of channel numbers. However, the channel number allotment to the various frequencies may be different in different countries. In order to adapt the receiver to the conditions in various countries, the whole programming part would have to be changed or replaced. As this is not done, the whole receiver would be useless in another country, because the user would not know how to tune it to a particular station he wants.

Therefore, it is an object of the present invention to provide a superheterodyne receiver and a method of controlling a channel display which avoids the above mentioned disadvantage, i.e. which can be used in any country of the world without any difficulty, by using frequency information only.

This object is solved by a receiver of the above mentioned kind which according to the invention comprises arithmetic operating means for converting said frequency data into channel data, and channel display means controlled by said channel data and comprising a channel number display portion and a channel index display portion, said arithmetic operation means comprising: subtracting means for subtracting from said frequency data a preset numerical value representing the minimum frequency to be received; dividing means for dividing the result of the subtraction by a preset number representing the number of different broadcasting frequencies grouped into each channel; adding means for adding to the quotient of the division a preset number representing the channel number allotted to said minimum frequency; and a remainder determining means determining the remainder of said division, said channel number display portion being controlled by the output of said adding means and said channel index display portion being controlled by said remainder determining means.

On the other hand the above mentioned disadvantage is avoided by a method for controlling a channel display in a superheterodyne receiver of the above mentioned kind which shows the steps of converting said frequency data into channel number data by arithmetic operation comprising subtracting from said frequency data a preset numerical value representing the minimum frequency to be received; dividing the result of said subtraction by a preset number representing the number of different broadcasting frequencies grouped into one channel; adding to the quotient of said division a preset number representing the channel number allotted to said minimum frequency, and using the result of the addition for controlling the display of the channel number and determining the remainder of said division and using the result of said remainder determination for controlling the channel index display.

With the invention the programming part is structured in terms of frequency data and as there is also a frequency display controlled by said frequency data, the receiver can be used in any country of the world without any difficulty, by using frequency information only. Only for the additional channel number display, the receiver would have to be adapted to a channel number system of a particular country, and this can be done very easily by simply exchanging the arithmetic operating means (translator) which converts the frequency value into a channel number. This is a very simple modification, which can be effected for example by replacing a ROM memory in which the data determining the allotment of the channel numbers to the various frequencies can be stored. However, even if this is not done, the worst thing that could happen when using the receiver in another country would be that the channel number display is faulty, whilst still enabling the user to use and tune the receiver.

The further features, aspects and advantages of the present invention will be understood from the following detailed description of a preferred embodiment of the present invention when taken in conjunction with the accompanying drawings.

Fig. 1 is a block diagram showing an outline of one embodiment of the present invention;

Fig. 2 is a block diagram showing in detail an operation means of the Fig. 1 embodiment;

Fig. 3 is a block diagram schematically showing a function of the operation means shown in Fig. 1 implemented by a microprocessor; and

Fig. 4 is a flow diagram for explaining an operation of the Fig. 3 embodiment.

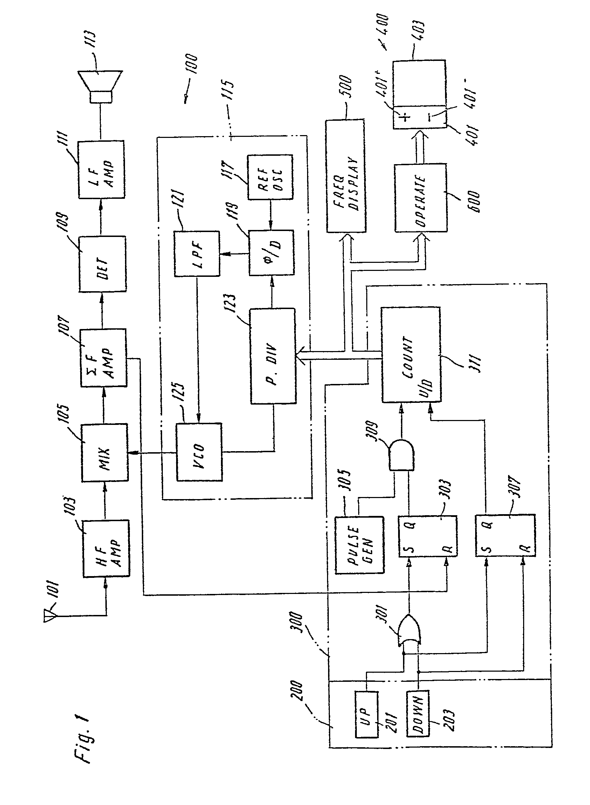

Fig. 1 is a block diagram showing one embodiment of the present invention. A high frequency signal received by an antenna 101 is amplified by a high frequency amplifier 103 and the output therefrom is applied to a mixer 105. The mixer 105 is connected to receive as a local oscillation signal the oscillation output obtained from a voltage controlled oscillator 125 included in a phase locked loop 115. Accordingly, in the mixer 105 the high frequency signal thus amplified is mixed with the local oscillation signal obtained from the voltage controlled oscillator to be converted into an intermediate frequency signal, which is then applied to an intermediate frequency amplifier 107. The output of the intermediate frequency amplifier 107 is detected by a detector 109 and a low frequency signal or an audio signal thus obtained is applied to a low frequency amplifier 111. The low frequency amplifier drives a speaker 113 in association with the audio signal applied thereto. An FM band radio receiver 100 is thus structured.

The phase locked loop 115 comprises a reference oscillator 117. The reference oscillator 117 comprises a crystal, for example, the output of which is applied to a phase comparator 119. The phase comparator 119 is further connected to receive at the other input thereto the output of a programmable frequency divider 123 connected to receive the oscillation output of the voltage controlled oscillator 125. Accordingly, the phase comparator 119 serves to compare the phases of the signal obtained from the reference oscillator 117 and the signal obtained from the programmable frequency divider 123, thereby to provide a voltage signal associated with the phase difference therebetween, which is applied through a low pass filter 121 to the above described voltage controlled oscillator 125 as a control voltage. The programmable frequency divider 123 is loaded, as a frequency division ratio, with the data obtained from a frequency division ratio setting counter 311 included in a frequency division ratio setting means 300.

The frequency division ratio setting means 300 is connected to an upward switch 201 for commanding an automatic scanning operation in the upward direction and a downward switch 203 for commanding an automatic scanning operation in the downward direction. The frequency division ratio data and thus the receiving frequency data obtained from the frequency division ratio setting means 300 is applied to a receiving frequency display 500 and also applied to an operation means 600. As to be more fully described subsequently, the operation means 600 is aimed to convert the receiving frequency data into channel number data and the output thereof is applied to a channel display 400. Such a frequency division ratio setting means is disclosed in United States Patent No. 4,088,959, filed May 4, 1976 and issued May 9, 1978 to the same assignee as the present invention and entitled "MULTIPLE BAND DIGITAL FREQUENCY SYNTHESIZER RECEIVER". Accordingly, the frequency division ratio setting means 300 will be briefly described herein mainly centering on a portion of interest to the present invention.

The upward switch 201 and the downward switch 203 are structured to provide a signal of the high level or the logic one upon depression or operation thereof. The signal obtained from the upward switch 201 and the signal obtained from the downward switch 203 are applied to an OR gate 301 included in the control circuit 300 and is also applied to the set input and the reset input of a flip-flop 307, respectively. The output of the OR gate 301 is applied to the set input of a flip-flop 303. The reset input of the flip-flop 303 is connected to receive a signal representative of a tuning state by the above described radio receiver 100 obtained from the intermediate frequency amplifier 107 thereof. Accordingly, the flip-flop 303 is set responsive to operation of either the upward switch 201 or the downward switch 203 and is reset responsive to the signal representative of a tuning state by the radio receiver 100. The non-inverted output of the flip-flop 303 is applied to one input of an AND gate 309. The other input of the AND gate 309 is connected to receive a pulse obtained from a pulse generator 305. The pulse generator 305 comprises an astable multivibrator, for example, and the output pulse thereof is applied to an AND gate 309. The pulse as obtained from the pulse generator 305 through the AND gate 309 serves as a station selecting pulse and is applied to a count input of the frequency division ratio setting counter 311. The frequency division ratio setting counter 311 is structured as an up/down counter and, in order to command the same as an up count mode or a down count mode, the non-inverted output of the above described flip-flop 307 is applied to this counter 311. More specifically, if and when the non-inverted output of the flip-flop 307 is the high lever or the logic one, this counter 311, operates in an up count mode and, if and when the non-inverted output of the flip-flop 307 is the low level or the logic zero, the counter 311 operates in a down count mode. The frequency division ratio setting counter 311 is provided with an attached circuit, not shown. The attached circuit is adapted such that when the count value in the frequency division ratio setting counter 311 is the data of the broadcasting frequency 87.5 MHz of the lowest channel, say Channel No. 2⁻ of the frequency band and when the downward switch 202 is operated in such a situation, the count value in the counter 311 is replaced by the data of the broadcasting frequency 108.5 MHz of the highest channel, say Channel No. 72⁻, of the frequency band. The attached circuit is further adapted such that, conversely to the above, when the count value of the frequency division ratio setting counter 311 is the data of the above described broadcasting frequency of 108.5 MHz and when the upward switch 201 is further operated, the count value in the counter 311 is replaced by the data of the above described broadcasting frequency of 87.5 MHz of the lowest channel. Accordingly, the frequency division ratio setting counter 311 is controlled such that a frequency varies between the frequency of 87.5 MHz of the lowest channel and the frequency of 108.5 MHz of the highest channel.

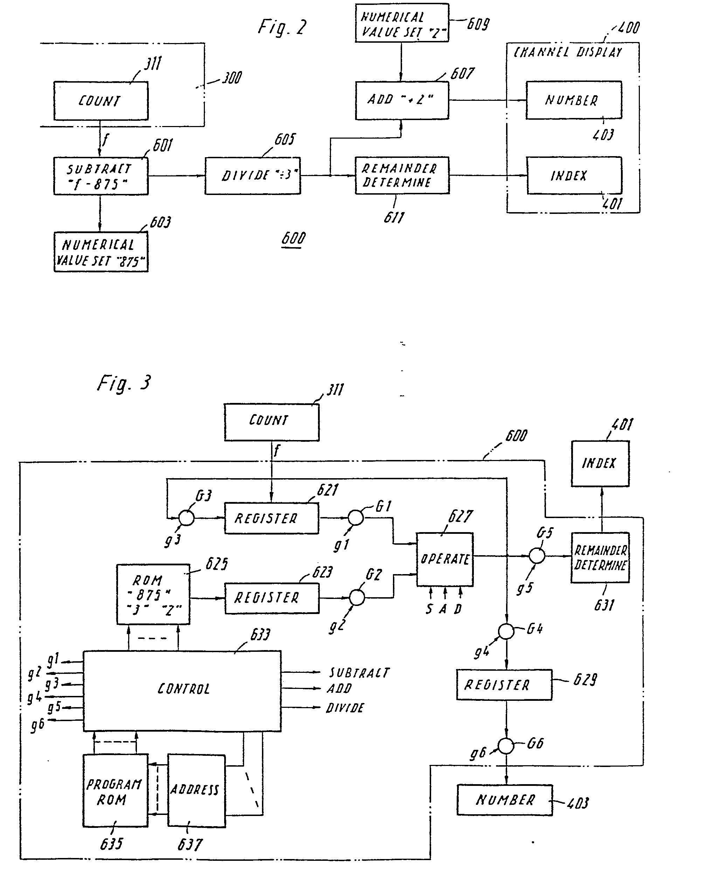

The count value in the frequency division ratio setting counter 311 included in the frequency division ratio setting means 300 is loaded in the programmable frequency divider 123 included in the phase locked loop 115 as a frequency division ratio and is also applied to the receiving frequency display 500, so that the receiving frequency is displayed by the display 500 in a digital manner. Meanwhile, in case of a lower side superheterodyne receiver, the local oscillation frequency is lower than the receiving frequency by a frequency difference commensurate with the intermediate frequency and therefore the programmable frequency divider performs in actually a frequency dividing operation at the value of the receiving frequency associated data minus the intermediate frequency associated data. The count value of the frequency division ratio setting counter 311 is further applied to the operation means 600. The operation means 600 is structured as shown in Figs. 2 and 3, for example. The output of an addition circuit 607 included in the operation means 600 is applied to a channel number display portion 403 of the channel display 400 and the output of a remainder determining circuit 611 is applied to an index display portion 401 of the channel display 400.

Referring to Fig. 2, the operation means 600 will be described in detail. The operation means 600 comprises a substraction circuit 601 for receiving the receiving frequency data obtained from the frequency division ratio setting means 300 and thus from the frequency division ratio setting counter 311. The substraction circuit 601 is also connected to receive, at the other input thereof, the numerical value "875" obtained from a numerical value setting circuit 603. The numerical value "875" set in the numerical value setting circuit 603 is selected to correspond to the broadcasting frequency of 87.5 MHz of the lowest channel, i.e. Channel No. 2⁻ which is receivable by the receiver. The subtraction circuit 601 subtracts the above described numerical value "875" from the receiving frequency data f obtained from the frequency division ratio setting counter 311 and supplies the difference thereof to a decision circuit 605. The division circuit 605 serves to divide the difference data obtained from the substraction circuit 601 by "3". The reason why the output of the substraction circuit 601 is divided by 3 by means of the division circuit 605 is that, as described previously, broadcasting frequencies of three independent channels have been allotted to each one channel number. The quotient data obtained by the division by means of the division circuit 605 is applied to one input of an addition circuit 607 and is also applied to a remainder determining circuit 611. The addition circuit 607 is also connected to receive, at the other input thereof, the numerical value "2" obtained from the numerical value setting circuit (609). The reason why the numerical value "2" is set in the numerical value setting circuit 609 is that the numerical value corresponding to the broadcasting frequency 87.5 MHz of Channel No. 2⁻ was set as the lowest frequency data in the above described numerical value setting circuit 603. More specifically, since the receiver is adapted such that Channel Nos. 0⁻, 0, 0⁺, 1⁻, 1 and 1⁺, at the lower extremity of the FM band are rendered unreceivable, it is intended that two channels rendered unreceivable are added as far as channel number data is concerned. Accordingly, the output of the addition circuit 607 is obtained as the channel number data. On the other hand, the remainder determining circuit 611 determines whether a remainder occurs in the result of the division by the division circuit 605 and if a remainder has occurred, whether the remainder is "1" or "2". The remainder determining circuit 611 provides a signal representing that the channel index is "−" when the remainder is "0" and a signal representing that the channel index is "+" when the remainder is "2".

Now that the structural features of the embodiment were described in the foregoing, an operation of the embodiment will be described in the following. Now consider that in an initial condition the count value in the counter 311 included in the frequency division ratio setting means 300 is the data "875" corresponding to the frequency of 87.5 MHz. Therefore, in such initial condition, the receiving frequency data "875" is loaded in the programmable frequency divider 123 included in the phase locked loop 115 as a frequency division ratio. At the same time, a decimal point display portion, not shown, is enabled in the frequency display 500. As a result, the frequency data of 87.5 MHz is displayed in a digital manner by the frequency display 500. On the other hand, the operation means 600 makes subtraction by the subtraction circuit 601 with respect to the frequency data "875" obtained from the counter 311 and the numerical value "875" obtained from the numerical value setting circuit 603. Accordingly, in the initial condition, the difference output of the subtraction circuit 601 is "0". Therefore, the quotient output of the division circuit 605 is "0". Thus, the output of the addition circuit 607 becomes "2". On the other hand, since the quotient is "0", the remainder determining circuit 611 also determines the remainder as "0", thereby to provide a signal representing the channel index as "−". Accordingly, the channel number "2" is displayed by the channel number display portion 403 and the channel index 401⁻ is displayed by the channel index display portion 401 in the channel display 400.

Now consider a case where the upward switch 201 is operated in the above described initial condition. Upon manual operation of the upward switch 201, the flip-flop 307 is set responsive to the signal obtained from the upward switch 201 and the flip-flop 303 is set responsive to the signal obtained from the upward switch 201 through the OR gate 301. As the flip-flop 307 is set, the non-inverted output thereof becomes the high level or the logic one, whereby the frequency division ratio setting counter 301 is rendered in an up count mode. Since at the same time the non-inverted output of the flip-flop 303 becomes the high level or the logic one, the pulse obtained from the pulse generator 305 is applied through the AND gate 309 to the count input of the frequency division ratio setting counter 311 as a station selecting pulse. When the first station selecting pulse is received, the counter 311 counts "876". Therefore, the receiving frequency data "876" is loaded in the programmable frequency divider 123 included in the phase locked loop 115 as a frequency division ratio. At the same time, a decimal point display portion, not shown, is enabled in the frequency display 500. As a result, the frequency data of 87.6 MHz is displayed in a digital manner by the frequency display 500. On the other hand, the operation means 600 makes subtraction by the subtraction circuit 601 with respect to the frequency data "876" obtained from the counter 311 and the numerical value "875" obtained from the numerical value setting circuit 603. Accordingly, the difference output of the subtraction circuit 601 is "1". Therefore, the quotient output of the division circuit 605 is "0". On the other hand, the remainder determining-circuit 611 also determines the remainder as "1", thereby to provide a signal representing the channel index being neither "−" nor "+". Accordingly, the channel number "2" is displayed by the channel number display portion 403 and the channel index display portion 401 in the channel display 400 is not enabled.

Thereafter the second pulse is applied from the pulse generator 305 through the AND gate 309 to the frequency division ratio setting counter 311 as a station selecting pulse. Then the counter 311 counts the same and the count value in the counter 311 becomes "877". Therefore the receiving frequency data "877" is loaded in the programmable frequency divider 123 included in the phase locked loop 115 as a frequency division ratio. At the same time, a decimal point display portion, not shown, is enabled in the frequency display 500. As a result, the frequency data of 87.7 MHz is displayed in a digital manner by the frequency display 500. On the other hand, the operation means 600 makes subtraction by the subtraction circuit 601 with respect to the frequency data "877" obtained from the counter 311 and the numerical value "875" obtained from the numerical value setting circuit 603. Accordingly, the difference output of the subtraction circuit 601 is "2". On the other hand, the remainder determining circuit 611 also determines the remainder as "2", thereby to provide a signal representing the channel index as "+". Accordingly, the channel number "2" is displayed by the channel number display portion 403 and the channel index 401⁺ is displayed by the channel index display portion 401 in the channel display 400.

Then the third station selecting pulse is applied from the station selecting pulse generator 305 to the frequency division ratio setting counter 311 and the counter 311 becomes "878". Therefore, the receiving frequency data "878" is loaded in the programmable frequency divider 123 included in the phase locked loop 115 as a frequency division ratio. At the same time, a decimal point display portion, not shown, is enabled in the frequency display 500. As a result the frequency data of 87.8 MHz is displayed in a digital manner by the frequency display 500. On the other hand, the operation means 600 makes subtraction by the subtraction circuit 601 with respect to the frequency data "878" obtained from the counter 311 and the numerical value "87.5" obtained from the numerical value setting circuit 603. Accordingly, the difference output of the subtraction circuit 601 is "3". Therefore, the quotient output of the division circuit 605 is "1". Thus, the output of the addition circuit 607 becomes "3". On the other hand, the remainder determining circuit 611 also determines the remainder as "0", thereby to provide a signal representing the channel index as "−". Accordingly, the channel number "3" is displayed by the channel number display portion 403 and the channel index 401⁻ is displayed by the channel index display portion 401 in the channel display 400. Thereafter, in a similar manner, each time a station selecting pulse is obtained from the pulse generator 305, the data displayed by the frequency display 500 and the channel display 400 is renewed.

Now description is made of a case where the downward switch 203 is temporarily operated in the initial condition, i.e. when the count value in the frequency division setting counter 311 is "875". In such a case, as in case of operation of the upward switch 201, the flip-flop 303 is set. On the other hand, the flip-flop 307 is reset, so that the non-inverted output becomes the low level or the logic zero. Accordingly, the frequency division ratio setting counter 311 is brought to the down count mode. The pulse obtained from the pulse generator 305 is applied through the AND gate 309 to the counter 311. However, the count value in the counter 311 is "875" and the attached circuit, not shown, determines the state, thereby to change the count value in the frequency division ratio setting counter 311 to "1085". Accordingly, in such a case, the counter 311 makes a down count operation responsive to each station selecting pulse, starting from "1085".

Fig. 3 is a block diagram schematically showing the function of the operation means 600 in Fig. 1 in case where the same is implemented by a well known microprocessor or microcomputer. Referring to Fig. 3, a read only memory 625 has been loaded with three pieces of data "875", "3" and "2" in the respective prescribed addresses. The read only memory 625 is addressed by means of a control circuit 633 through cooperation with other gate circuits G1 to G6 and an operation circuit 627, such that a read operation is controlled. The control circuit 633 also provides an addressing signal in order to address a program memory 635, which may also comprise a read only memory. Accordingly, the addressing signal is loaded in an address register 637 and the program memory 635 is addressed thereby. The program memory 635 provides a command signal to the control circuit 633 in association with the address as addressed. Accordingly, the control circuit 633 supplies a command signal of subtraction addition or division to the operation control circuit 627 in accordance with the program stored in the program memory 635 and suitably controls opening and closing of the gate circuits G1 to G6. Registers 621, 623, and 629 shown in Fig. 3 are implemented by a portion of a random access memory, not shown.

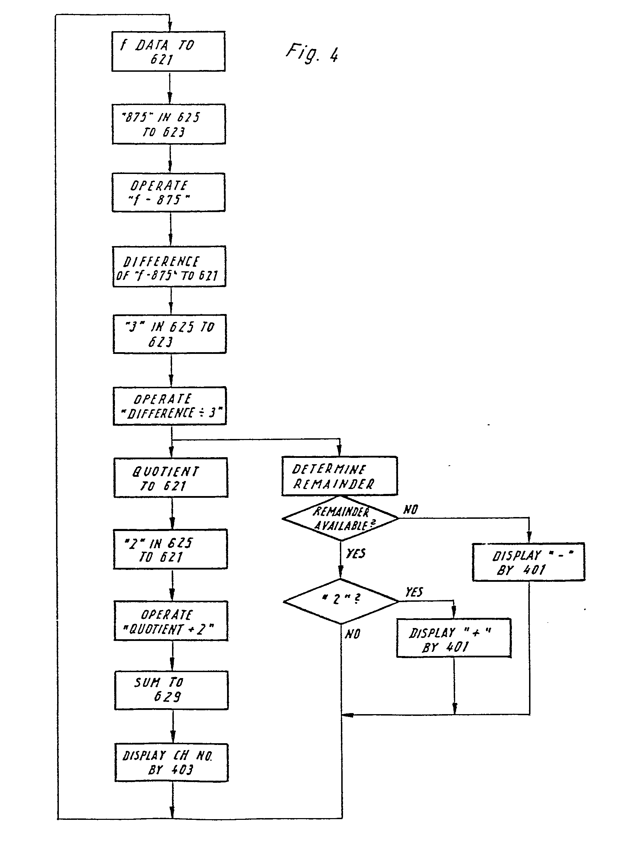

Fig. 4 is a flow diagram for explaining an operation of the Fig. 3 embodiment. Now referring to Fig. 4, an operation of the Fig. 3 embodiment will be described in the following. In operation, let it be assumed that the numerical value "899" has been loaded in the frequency division ratio setting counter 311 included in the frequency division setting means 300, by way of an example. Accordingly, the radio receiver 100 is receiving the broadcasting frequency of 89.9 MHz. In such a situation, the control circuit 633 operates to load the data "899" obtained from the frequency division ratio setting means 300 to the first register 621. Then the control circuit 633 addresses the read only memory 625, so that the numerical value "875" is read from the read only memory 625, which is then loaded in the second register 623. Then the control circuit 633 provides gate signals G1 and G2, so that the gate circuits G1 and G2 are opened. Accordingly the operation circuit 627 receives the numerical value "899" loaded in the first register 621 and the numerical value "875" loaded in the second register 623. In such a situation, the operation circuit 627 has been supplied with the subtraction command signal from the control circuit 633. Accordingly, the operation circuit 627 makes a subtracting operation of "899—875". Thereafter the control circuit 633 provides a gate signal G3, so that the corresponding gate G3 is opened. Accordingly, the difference "24" obtained by the operation by means of the operation circuit 627 is again loaded in the first register 621.

Then the control circuit 633 addresses the read only memory 625, so that the numerical value "3" is obtained from the read only memory 625. The above described numerical value "3" is loaded in the second register 623. The control circuit 633 again provides the gate signals G1 and G2, so that the gate circuits G1 and G2 are opened. Accordingly, the operation circuit 627 receives the numerical values "24" and "3". At the same time, the operation circuit 627 has been supplied with a division command from the control circuit 633. Therefore, the operation circuit 627 performs a dividing operation of "24 ÷ 3". The control circuit 633 again provides the gate signal G3. Accordingly, the quotient "8" obtained by the operation by means of the operation circuit 627 is again loaded in the first register 621. At that time the control circuit 633 provides the gate signal G5. Accordingly, the remainder obtained as a result of division by means of the operation circuit 627 is applied to the remainder determining circuit 631. At that time, the remainder determining circuit 631 determines the remainder being "0" and the channel index 401⁻ of the channel index display 401 is enabled.

On the other hand, the control circuit 633 then addresses the read only memory 625, so that the numerical value "2" is read therefrom. The above described numerical value "2" is loaded in the second register 623. Then the control circuit 633 provides the gate signals G1 and G2. Accordingly, the operation circuit 627 receives the numerical values "8" and "2". At the same time, the operation circuit 627 is supplied with an addition signal obtained from the control circuit 633. Accordingly, the operation circuit 627 performs an adding operation of "8 + 2". Thereafter, the control circuit 633 provides the gate signals G4 and G6. Accordingly, the sum "10" obtained as a result of addition by the operation circuit 627 is transferred to the third register 629 and is applied to the channel number display portion 403 as channel number data.

Thus it is indicated that the broadcasting frequency presently in reception is 89.9 MHz and the Channel No. 10⁻.

Thereafter, as described previously, each time a station selecting pulse is received from the AND gate 309, for example, the counter 311 included in the frequency division ration setting means 300 makes an up count or down count and accordingly the frequency division ratio data is loaded in the frequency division ratio setting counter 311. Thus the operation means 600 can serve to display the channel in terms of the channel number and the channel index on the basis of the operation described previously, i.e. the operation as shown in Fig. 4. More specifically, each time a station selecting pulse is received, the frequency division ratio setting data is changed by "1", so that the oscillation frequency of the voltage controlled oscillator 125 is also changed by 100 kHz. Thus, the channel index is changed for every 100 kHz, while the channel number data is changed for every 300 kHz.

The above described embodiment was adapted such that the numerical value "875" corresponding to the broadcasting frequency of the lowest channel, i.e. Channel No. 2⁻ which is receivable by the receiver was set as data corresponding to the broadcasting frequency of the lowest channel. However, alternatively, the data "869" corresponding to the broadcasting frequency of the lowest channel, i.e. Channel No. 0⁻ allotted to the frequency band may be set. In such a case, it is not required that the quotient obtained as a result of division is divided by "3" and then the value "2" is added thereto. In such a case, it is required that the counter 311 of the frequency division ratio setting means 300 is changeable up to the data "869" corresponding to the lowest broadcasting frequency.

Although the present invention has been described and illustrated in detail, it is to be clearly understood that the same is by way of illustration and example only and is not to be taken by way of limitation, the scope of this invention being limited only by the terms of the appended claims.

**Claims**

1. A superheterodyne receiver comprising:
frequency data setting means (300) controlled by programming means (200) for setting frequency data corresponding to the value of a frequency to be received;
frequency display means (500) controlled by said frequency data for displaying the set frequency value;
voltage generating means (115) responsive to said frequency data for generating a control voltage for a local oscillator (125) included in the tuning part of the receiver, characterized by:
arithmetic operating means (600) for converting said frequency data into channel data,
and channel display means (400) controlled by said channel data and comprising a channel number display portion (403) and a channel index display portion (401), said arithmetic operating means comprising:
subtracting means (601) for subtracting from said frequency data a preset numerical value (875) representing the minimum frequency to be received;
dividing means (605) for dividing the result of the subtraction by a preset number (3) representing the number of different broadcasting frequencies grouped into each channel;
adding means (607) for adding to the quotient of the division a preset number (2) representing the channel number allotted to said minimum frequency;
and a remainder determining means (511) determining the remainder of said division,
said channel number display portion being controlled by the output of said adding means (607) and said channel index display portion (401) being controlled by said remainder determining means (611).

2. A method for controlling a channel display in a superheterodyne receiver including a voltage controlled local oscillator, frequency data setting means controlled by programming means for setting a frequency data associated with a receiving frequency to be selected for controlling the generation of the control voltage for the local oscillator, characterized in that it comprises the steps of converting said frequency data into channel number data by arithmetic operation comprising
subtracting from said frequency data a preset numerical value (875) representing the minimum frequency to be received;
dividing the result of said subtraction by a preset number (3) representing the number of different broadcasting frequencies grouped into one channel;
adding to the quotient of said division a preset number (2) representing the channel number allotted to said minimum frequency, and using the result of the addition for controlling the display of the channel number and determining the remainder of said division and using the result of said remainder determination for controlling the channel index display.

**Patentansprüche**

1. Superhetempfänger mit:
einer Frequenzdatensetzvorrichtung (300), die durch eine Programmiervorrichtung (200) gesteuert wird, um die Frequenzdaten entsprechend dem Empfangsfrequenzwert zu setzen;
eine Frequenzanzeigevorrichtung (500), die durch die Frequenzdaten gesteuert wird, um den gesetzten Frequenzwert anzuzeigen;

eine Spannungserzeugungsvorrichtung (115), die in Abhängigkeit von den Frequenzdaten eine Steuerspannung für einer Überlagerungsoszillator (125) erzeugt, der im Abstimmteil des Empfängers enthalten ist, gekennzeichnet durch:

Ein arithmetisches Rechenwerk (600) zum Umsetzen der Frequenzdaten in Kanaldaten und eine Kanalanzeigevorrichtung (400), die durch die Kanaldaten gesteuert wird und einen Kanalnummernanzeigeteil (403) und einen Kanalindexanzeigeteil (401) enthält,

wobei das arithmetische Rechenwerk enthält:

Ein Subtrahierwerk (601) zum Subtrahieren eines gesetzten Wertes (875), welcher die minimale Empfangsfrequenz repräsentiert, von den Frequenzdaten;

ein Dividierwerk (605) zum Dividieren des Resultats der Subtraktion durch einen gesetzten Wert (3), der die Anzahl der in jedem Kanal angeordneten unterschiedlichen Sendefrequenzen repräsentiert;

ein Addierwerk (607) zum Addieren eines gesetzten Wertes (2), der die der Minimalfrequenz zugeordnete Kanalnummer repräsentiert, zum Quotienten der Division;

und eine Restbestimmungsvorrichtung (611), die den Rest der Division bestimmt,

wobei der Kanalnummernanzeigeteil durch den Ausgangswert des Addierwerks (607) gesteuert wird und der Kanalindexanzeigeteil (401) durch den Ausgangswert der Restbestimmungsvorrichtung (611).

2. Verfahren zur Steuerung einer Kanalanzeige in einem Superhetempfänger, der einen spannungsgesteuerten Überlagerungsoszillator aufweist, eine Frequenzdatensetzvorrichtung, die durch eine Programmiervorrichtung gesteuert wird, um die Frequenzdaten, die zum gewählten Empfangsfrequenzwert gehören, zu setzen, um die Erzeugung der Steuerspannung für den Überlagerungsoszillator zu steuern, dadurch gekennzeichnet, daß es die Verfahrensschritte aufweist:

Umsetzen der Frequenzdaten in Kanalnummerndaten durch eine arithmetische Operation, die enthält:

Subtrahieren eines gesetzten Zahlenwertes (875), der die minimale Empfangsfrequenz repräsentiert, von den Frequenzdaten;

Dividieren des Ergebnisses der Subtraktion durch einen gesetzten Wert (3), der die Anzahl der in jedem Kanal angeordneten unterschiedlichen Sendefrequenzen repräsentiert;

Addieren eines gesetzten Wertes (2), der die der Minimalfrequenz zugeordnete Kanalnummer repräsentiert zum Quotienten der Division,

und Benutzen des Ergebnisses der Addition zum Steuern der Anzeige der Kanalnummer und Bestimmen des Rests der Division und Benutzen der Ergebnisses der Restbestimmung zum Steuern der Kanalindexanzeige.

**Revendications**

1. Récepteur superhétérodyne, comprenant un ensemble de réglage (300) des données de fréquence commandé par un ensemble de programmation (200) pour régler les données de fréquence correspondant à la valeur d'une fréquence à recevoir; un ensemble d'affichage de fréquences (500) commandé par la donnée de fréquence pour afficher la valeur de fréquence réglée; un ensemble générateur de tension (115) réagissant à ladite donnée de fréquence en engendrant une tension de commande à destination d'un oscillateur local (125) inclus dans la section d'accord du récepteur, caractérisé en ce qu'il comprend: un ensemble de calcul arithmétique (600) pour convertir les données de fréquence en données de canal, et un ensemble d'affichage de canaux (400) commandé par la donnée de canal et comprenant une section d'affichage de numéro de canal (403) et une section d'affichage d'indice de canal (401), ledit ensemble de calcul arithmétique comprenant: un ensemble soustracteur (601) pour soustraire de la donnée de fréquence une valeur numérique prédéterminée (875) représentant la fréquence minimale à recevoir; un ensemble diviseur (605) pour diviser le résultat de la soustraction par un nombre prédéterminé (3) représentant le nombre de fréquences d'émission différentes groupées dans chaque canal; un ensemble additionneur (607) pour ajouter au quotient de la division un nombre prédéterminé (2) représentant le numéro de canal attribué à la fréquence minimale; et un ensemble de détermination du reste (611) déterminant le reste de ladite division, ladite section d'affichage de numéros de canal étant commandée par la sortie de l'ensemble additionneur (607) et ladite section d'affichage d'indice de canal (401) étant commandée par l'ensemble de détermination du reste (611).

2. Procédé pour commander un affichage de canaux dans un récepteur superhétérodyne comprenant un oscillateur local à fréquence réglée par variation de tension, un ensemble de réglage de données de fréquence commandé par l'ensemble de programmation pour régler une donnée de fréquence associée à une fréquence de réception à choisir pour commander la génération de la tension de commande à destination de l'oscillateur local, caractérisé en ce qu'il comprend les stades consistant à convertir la donnée de fréquence en donnée de numéro de canal par des opérations arithmétiques consistant à soustraire de ladite donnée de fréquence une valeur numérique prédéterminée (875) représentant la fréquence minimale à recevoir; diviser le résultat de cette soustraction par un nombre prédéterminé (3) représentant le nombre de fréquences d'émission différentes groupées dans chaque canal; ajouter au quotient de cette division un nombre prédéterminé (2) représentant le numéro de canal attribué à ladite fréquence minimale, et utiliser le résultat de l'addition pour commander l'affichage du numéro de canal, et déterminer le reste de ladite division et utiliser le résultat de cette détermination du reste pour commander l'affichage de l'indicatif du canal.

Fig. 1

Fig. 2

Fig. 3

Fig. 4

f DATA TO
621

"875" IN 625
TO 623

OPERATE
"f - 875"

DIFFERENCE
OF "f-875" TO 621

"3" IN 625 TO
623

OPERATE
"DIFFERENCE ÷ 3"

QUOTIENT
TO 621

DETERMINE
REMAINDER

REMAINDER
AVAILABLE? — NO

YES

"2"? — YES

NO

DISPLAY "-"
BY 401

DISPLAY "+"
BY 401

"2" IN 625
TO 621

OPERATE
"QUOTIENT + 2"

SUM TO
629

DISPLAY CH NO.
BY 403